# EUROPEAN PATENT APPLICATION

(11) **EP 4 199 011 A1**
(43) Date of publication of application: **21.06.2023**
(21) Application number: 20949471.5
(22) Date of filing: 14.08.2020
(51) Int. Cl.: H01F 1/057, H01F 7/02, B22F 9/08, C22C 33/02

(54) **METHOD FOR OBTAINING AN NDFEB PRECURSOR MATERIAL, PRECURSOR MATERIAL THUS OBTAINED, METHOD FOR OBTAINING A MAGNET COMPRISING THE PRECURSOR MATERIAL AND MAGNET THUS OBTAINED**

(71) Applicant: Asociacion Centro Tecnologico Ceit, 20018 Donostia - San Sebastian (Guipuzcoa) (ES)
(72) Inventor: SARRIEGUI ESTUPIÑAN, Gabriela Carolina, 20018 Donostia (Gipuzkoa) (ES); MARTIN GARCIA, José Manuel, 20018 Donostia (Gipuzkoa) (ES); BURGOS GARCIA, Nerea, 20018 Donostia (Gipuzkoa) (ES); CHECA FERNANDEZ, Blanca Luna, 20018 Donostia (Gipuzkoa) (ES)
(74) Representative: Evens, Paul Jonathan
(86) International application number: PCT/ES2020/070513
(87) International publication number: WO 2022/034248

(57) **Abstract**

The present invention refers to a procedure for obtaining a precursor material from a melt NdFeB alloy, in which an atomisation stage is carried out until obtaining an average particle size between 30 and 250 microns, followed by a stage of annealing the particles obtained in the prior atomisation stage at a temperature between 1,000 and 1,180 ºC during a period of time between 1 and 1,000 hours.

## Description

### Field of the art

The invention refers to a process for obtaining a precursor material of NdFeB that is suitable for obtaining magnets. Therefore, the invention is included in the field of magnetic materials.

### State of the art

A neodymium magnet (also known as an NdFeB magnet) is the most widely used type of rare earth magnet; it is a permanent magnet made from an alloy of neodymium, iron, and boron, combined to form a composite that crystallises in the tetragonal crystal structure under the empirical formula Nd2Fe14B. This material has exceptionally high crystalline anisotropy, which gives the compound the potential of having a very high coercivity (resistance to being demagnetised).

There are two main ways of manufacturing NdFeB magnets:
- Conventional powder metallurgy, also known as sintered magnet process, which is a process of manufacturing moulded solid pieces that consists of compacting several metallic and/or ceramic powders into a homogeneous mixture at high pressure and, once compacted, subjecting them to a heat-treatment at a temperature below the fusion temperature of the mixture.
- Rapid solidification, also known as bonded magnet process.

Currently, NdFeB alloy sintered magnets are the magnets that can provide maximum energy products, so the devices that require the highest total power or volume reduction tend to use this type of materials.

However, the cost of NdFeB magnets can increase the cost of the device, depending on different variables, such as for example the price of rare earths. This is why other types of magnets are still in use for certain applications.

As mentioned above, another manufacturing option is bonded magnets; these NdFeB-based magnets are the main option capable of being used in electric motors and other technological applications. This is due mainly to the possibility of producing this type of magnets with complicated geometries or in small dimensions and with high precision finishes, which makes it unnecessary to rectify the samples, thus generating savings in materials and processing.

However, these magnets have lower magnetic properties in comparison with sintered magnets, since the proportion of magnetic material is lower and since the microstructure thereof is different. Nevertheless, they are still a good option for different applications due to the savings they generate and the ease of production thereof.

There are different compositions and ways to produce base magnetic powders to manufacture NdFeB bonded magnets. The most common way of producing them is by melt-spinning, which produces a ribbon shaped isotropic material with a nanometric grain size. This method is based on rapid solidification of the melt alloy by pouring it onto an internally refrigerated copper spinning wheel, thus controlling the microstructure of the material. Although it is true that isotropic materials have lower magnetic properties than anisotropic ones, they have the advantage that, since they are not oriented during the consolidation thereof, they are more easily consolidated as magnets, and therefore, cheaper. Once consolidated, they can be magnetised equally in any direction.

Another way of producing NdFeB-based isotropic powder is by means of atomisation; although the magnetic properties obtained for this type of powders are lower than those of powders obtained by means of melt-spinning, this is a cheaper production method since it is possible to atomise a much higher amount of material than with melt-spinning. In addition, the spherical form of the atomised powders provides the powder mixture with a lower viscosity than other powders, which makes it easier to mould, thus making it possible to increase the production of magnetic material per sample and allowing the production of more complex and/or smaller geometric samples.

Another method for producing magnetic powder is by treating NdFeB-based alloys with hydrogen heat cycles. This technique, known as HDDR (Hydrogenation Disproportionation, (HD) Desorption Recombination, (DR)) makes it possible to reduce the grain size of the initial alloy to up to 0.3 µm. As for the orientation of the grains, it is possible to maintain the orientation of the original grains to a large degree, depending on how the process is carried out.

This HDDR process makes it possible to obtain anisotropic powder from a monocrystalline powder when treated with the appropriate cycle, which makes it possible to obtain higher magnetic properties than those obtained with the other classes of bonded magnets.

The HDDR treatment of a monocrystalline powder of an NdFeB-based alloy (to provide anisotropy and therefore better magnetic properties) is already known. More specifically, it has been achieved by using an NdFeB alloy and applying an AICHI STEEL cycle (Y. Honkura, N. Hamada and C. Mishima, Process for producing anisotropic magnet powder, US patent. No. 7,138,018, of 21 November 2006). However, the processing parameters need to be adjusted depending on the composition, the size of the facility, etc.

Therefore, there is the need to find a magnet that has good magnetic properties and that can be manufactured having complex geometries or small dimensions, and with a high precision finish in order to be used in electric motors and other technological applications.

### Description of the invention

With the aim of addressing the aforementioned drawbacks, the authors of the present invention have developed a procedure for obtaining an NdFeB precursor material that is used to obtain NdFeB magnets, that comprises an atomisation stage followed by a stage of annealing the particles obtained in the atomisation stage, as detailed below. In a first aspect, the invention refers to a procedure for obtaining an NdFeB magnetic powder from a melt NdFeB alloy, comprising the following stages:
- atomising the melt NdFeB alloy until obtaining an average particle size between 30 and 250 microns, measured by means of laser diffraction, and
- annealing the particles obtained in the prior atomisation stage at a temperature between 1,000 and 1,800 ºC during a period of time between 1 and 1,000 hours.

### Atomisation

The atomisation stage of the procedure of the invention makes it possible to obtain an equiaxed, polycrystalline powder. The atomisation conditions can be adjusted in order to obtain the desired particle size.

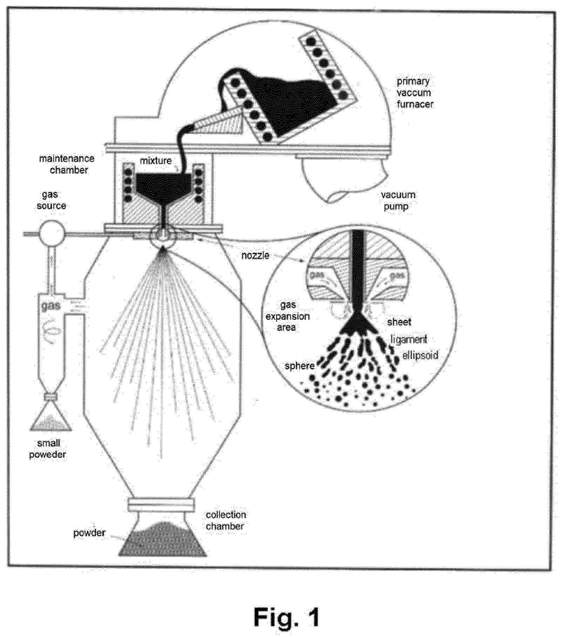

During the process of manufacturing powders by means of gas atomisation, which is illustrated schematically on Figure 1, the raw materials (in their elemental form, from master alloys and/or pre-alloyed powders) are loaded in suitable proportions into a furnace, where they are melted in order to obtain a mixture with a homogeneous composition. This mixture is directed by means of a supply pipe towards the atomisation chamber. On the outlet of the pipe, the jet of mixture is impacted by a gas current that causes it to fragment into microscopic drops, which solidify into powder. Both the chamber of the furnace and the atomisation chamber are then evacuated and refilled with argon in order to minimise the oxygen content of the final powder. The atomisation conditions that can be adjusted in order to obtain the desired particle size are: (1) inert atomisation gas (preferably argon, but others can be used such as nitrogen, helium, neon, etc.) (2) pressure of the atomisation gas (preferably between 30 and 100 bars, but between 2 and 200 bars is also possible) (3) gas/metal mass flow rate ratio (GMR, from "Gas/Metal mass flow rate Ratio", preferably between 0.5 and 2, but between 0.1 and 5 is also possible) and (4) overheating the mixture (preferably between 100 and 200 ºC, but between 50 and 500 ºC is also possible).

A preferred technique for obtaining the particle size in said atomisation stage is the laser diffraction technique. Laser diffraction equipment gives a histogram as a result: Volume percentage versus particle size. From this data, there are many different ways of describing this distribution.

The procedure to measure the particle size is as follows. When a powder is atomised, a representative sample of the powder is taken and the particle size distribution is measured by means of laser diffraction. This makes it possible to obtain a cumulative statistical distribution, from which the desired percentile or the median can be determined.

In the present invention, the following are used as reference: the 10% (D10) percentile, the median (D50), and the 90% (D90) percentile. These values inform of the average particle size (D50) and the width of the distribution (for example, D90-D10). However, there are other ways of describing a statistical distribution of particle sizes that are applicable to the procedure of the invention, such as, for example, using the arithmetic median to estimate the average size.

The maximum particle size of the atomised powder must be below 250 microns since, for this size, the structure of the powder obtained by means of atomisation contains flat particles that are not desirable for the process. Particles with a size above 250 microns are always flat (flakes). The atomisation conditions can be adjusted so that the fraction of particles above 250 microns is practically negligible.

On the other hand, if a very small powder is obtained, for example, with an average value below 30 microns, the resulting block would be too dense, which is very hard to transform in powder by means of a powder manufacturing treatment, such as grinding, or during the HDDR process. Therefore, although it is possible to atomise particles under said size (with the consequent annealing thereof in order to obtain the precursor material), in practice, the smaller the average size of the particle, the harder and more costly the HDDR process will be.

In a preferred embodiment, the D90 of the particles obtained by means of the atomisation process is comprised between 30 and 250 microns.

In another preferred embodiment, the D90 of the particles obtained by means of the atomisation process is comprised between 30 and 250 microns, preferably between 50 and 250 microns.

In a more preferred embodiment, the D90 of the particles obtained by means of the atomisation process is comprised between 95 and 150 microns.

In an even more preferred embodiment, the maximum particle size is set for a maximum of 150 microns with the following percentile distribution, in order to ensure the total absence of flat particles.

In another preferred embodiment, the D50 of the particles obtained during the atomisation stage is comprised between 10 and 70 microns.

In a more preferred embodiment, the D50 of the particles obtained during the atomisation stage is comprised between 25 and 60 microns.

In another preferred embodiment, the D10 of the particles obtained during the D10 atomisation stage is comprised between 3 and 15 microns.

In another more preferred embodiment, the D10 of the particles obtained during the atomisation stage is comprised between 5 and 12 microns.

In another preferred embodiment, the D50 of the particles obtained during the atomisation stage is comprised between 10 and 70 microns, the D10 is comprised between 3 and 15 microns, and the fraction by weight in powder under 250 microns is from 92% to 98.5% by weight, and the fraction of weight in powder under 150 microns is from 75% to 99% by weight.

In another more preferred embodiment, the D50 of the particles obtained during the atomisation stage is comprised between 25 and 60 microns, the D10 is comprised between 5 and 12 microns, and the fraction by weight in powder under 250 microns is from 92% to 92.5 % by weight, and the fraction by weight in powder under 150 microns is from 80% to 95 % by weight.

### Annealing

The process of annealing is carried out at a temperature range and during a predetermined time, causing the microstructure to change from polycrystalline to monocrystalline.

The temperature range in which the annealing process must be carried out in order to obtain the desired outcome must be between 1,000 and 1,180 ºC. Temperatures under 1,000 ºC do not cause the grain to grow, while temperatures above 1,180 ºC cause the material to change phases, so the desired microstructural change would not take place.

In a preferred embodiment, the preferred temperature range for obtaining optimal outcomes would be between 1,100 and 1,150 ºC. The time required during the annealing process in order to achieve the desired structural changes will depend on the temperature at which the annealing process is carried out.

Grain growth is a thermally activated phenomenon, that is, the higher the temperature is, the less annealing time is required to reach the desired grain size. If said time is exceeded, no additional advantages are obtained. Much to the contrary, the block can become denser (so it will be harder to reduce it to a powder, such as grinding, or HDDR), the material will oxidise more, and more time and energy will be spent on the process, increasing costs.

The times being considered are linked to the temperature so that, approximately, the extremes would be at a minimum time of at least 1 hour for a temperature of 1,180 ºC and a maximum time of 1,000 h for a temperature of 1,000 ºC.

The preferred time ranges, in accordance with the temperature ranges established as optimal, would be a minimum time of 10 hours for a temperature of 1,150 ºC, and a maximum time of 300 hours for 1,100 ºC.

In a preferred embodiment, the temperature in the annealing stage is comprised between 1,100 and 1,150 ºC, and the annealing time is comprised between 10 and 300 hours.

The fundamental composition of the magnets and the object of the invention is the Nd-Fe-B ternary alloy, although it can also contain residual or enhancing elements.

In order to avoid phase αFe from appearing in the final microstructure, which deteriorates the magnetic properties since it is a soft ferromagnetic phase, a minimum of rare earths above 28% by weight is required, and more exactly for this invention, the quantity by weight is set in the range of 28-31%. In term of rare earths, the fundamental elements to manufacture the material are Neodymium (Nd), Praseodymium (Pr), Lanthanum (La), Cerium (Ce), Dysprosium (Dy), Terbium (Tb), Gadolinium (Gd), Holmium (Ho).

In addition, iron will be the main component (around 65% by weight depending on the remainder of the concentrations), with the remainder being comprised by the remainder of the elements, while Boron (B) will have a small range between 0.8 and 1% by weight.

| **Element** | **Fe** | **Nd+Pr+La+Ce** | **B** | **Dy+Tb+Gd+Ho** | **Co+Cr+Mn+Ni** | **Al+Si** | **Ga** | **Cu** | **Nb+V+Zr** |
|---|---|---|---|---|---|---|---|---|---|
| % by weight | remainder | 15-36 | 0.8-1 | 0-15 | 0-15 | 0.2-2 | 0-3 | 0-3 | 0-4 |

In a preferred embodiment, the composition of the alloy used in the process for obtaining the NdFeB metallic powder is
Nd + Pr + La + Ce: 15 - 36 % by weight
B: 0.8 - 1 % by weight
Dy + Tb + Gd + Ho: 0 - 15 % by weight
Co + Cr + Mn + Ni: 0 - 15 % by weight
Al + Si: 0.2 - 2 % by weight
Ga: 0 - 3 % by weight
Cu: 0 - 3 % by weight
Nb + V + Zr: 0 - 4 % by weight
remainder: iron,
with the condition that the total content of rare earths is higher than 28% by weight.

In another preferred embodiment, the total content of rare earths comprises between 28 and 31% by weight.

For an HDDR process, an equiaxed powder is more desirable than a "flake" shaped one since the entry of hydrogen during the HD phase and the exit of hydrogen during the DR phase occurs more uniformly on the entire surface of the powder, and the resulting final microstructure is more homogeneous.

This material is especially suitable for HDDR treatment. The powder obtained by means of HDDR is especially suitable for making magnets by means of consolidation or compression moulding (in particular by means of bonding), since the powder is anisotropic and has an ultra-thin grain size (300 nm). It is not suitable for sintering since it would have to use temperatures of 1,100-1,150 ºC, which would drastically increase the grain growth, and the final properties thereof would be inappropriate.

Another aspect of the invention refers to the magnetic powder obtained by means of the procedure of the invention to obtain NdFeB metallic powder.

In a preferred embodiment, the process for obtaining NdFeB metallic powder comprises an HDDR treatment stage that is carried out after the annealing stage.

Another aspect of the invention refers to the magnet comprising the material obtained by means of the procedure of the invention to obtain NdFeB metallic powder.

Another aspect of the invention refers to a procedure for obtaining a magnet by means of consolidation or compression moulding of the material in the procedure of the invention for obtaining NdFeB magnetic powder.

In a preferred embodiment, consolidation is carried out by means of bonding.

### Description of the Figures

Figure 1 represents an illustrative schematic of the gas atomisation process according to R.M. German, Powder Metallurgy and Particulate Materials Processing, Metal Powder Industries Federation (MPIF), Princeton, NJ, U.S., 2005.
Figure 2 represents a microstructure of the atomised NdFeB powder.
Figure 3 represents a microstructure of the NdFeB powder annealed at 1,150 ºC during 10 hours.
Figure 4 represents a microstructure of the NdFeB powder annealed at 1100 ºC during 96 hours.
Figure 5 represents a microstructure of the NdFeB powder annealed at 1000 ºC during 300 hours.
Figure 6 represents a microstructure of the NdFeB powder annealed at 1200 ºC during 10 hours.
Figure 7 represents a microstructure of the NdFeB powder with 27% by weight thereof in Neodymium, annealed at 1,150 ºC during 24 hours.
Figure 8 represents a microstructure of the NdFeB powder with 31 % by weight thereof in Neodymium, annealed at 1,150 ºC during 24 hours.

### Preferred embodiment of the invention

### Examples

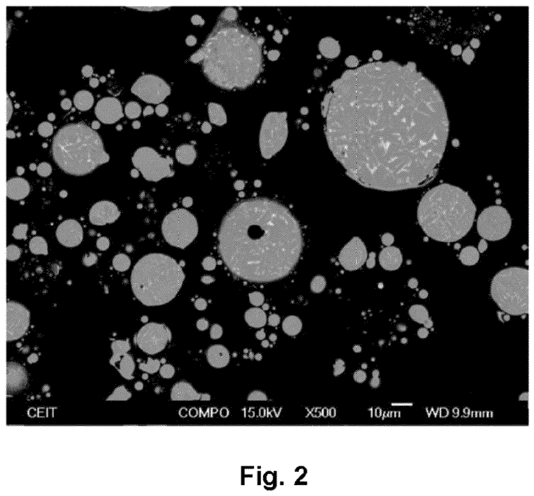

The starting material used in the examples is a polycrystalline atomised powder with an average size below 150 µm and a median of 20 µm. The initial microstructure is shown on Figure 2, where it can be observed that the particles are polycrystalline with a grain size under 10 microns.

### Example 1

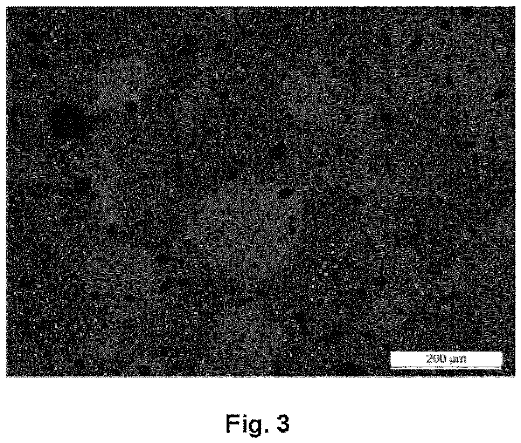

In a first exemplary embodiment, said atomised powder is annealed at a temperature of 1,150 ºC during 10 hours. Under these conditions, the desired grain growth is produced without there being a phase change. Figure 3 shows that the grain size has grown until reaching a value of approximately 110 microns.

### Example 2

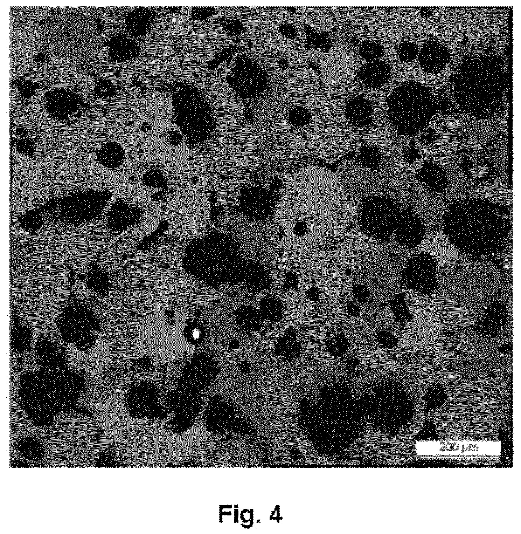

In another examplary embodiment, the annealing process is carried out at a temperature of 1,100 ºC during 96 hours. The material is subject to a longer period of annealing than the previous one, but at a lower temperature, which provides higher control of the grain size growth. Figure 4 shows that the grain size has grown until reaching a value of approximately 120 microns.

### Example 3

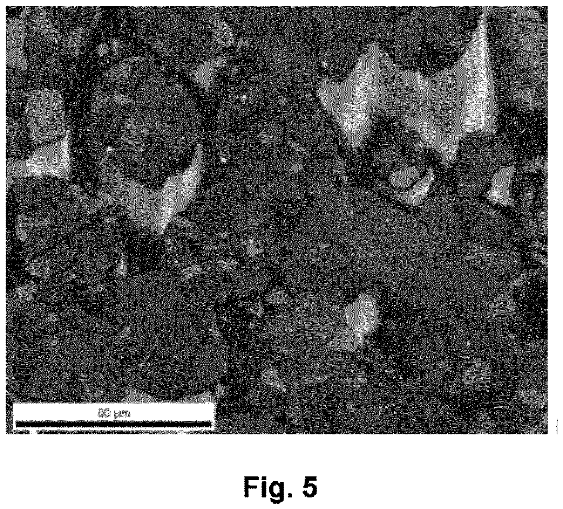

In another example embodiment, the atomised powder is subject to an annealing temperature of 1,000 ºC during 300 hours. This produces a much slower grain growth so it requires higher total energy consumption, increasing the costs of the process. Figure 5 shows that after such a long treatment, the grain size has barely grown, with the average size being approximately 10 microns.

### Example 4

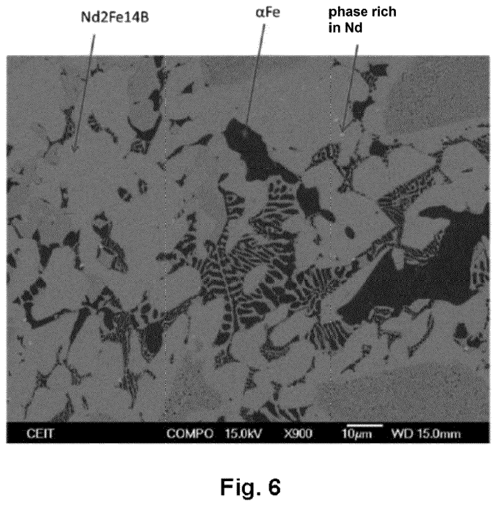

The atomised powder is subject to a temperature of 1,200 ºC during 10 hours. When exceeding the barrier of 1,180 ºC, a change in the microstructure takes place with the formation of a large quantity of αFe phase, which deteriorates the magnetic properties since it is a soft ferromagnetic phase (Figure 6).

### Example 5

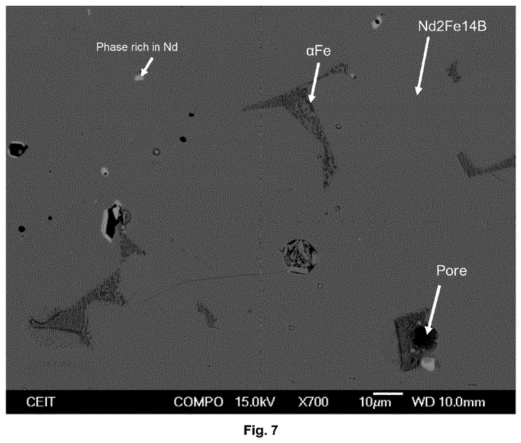

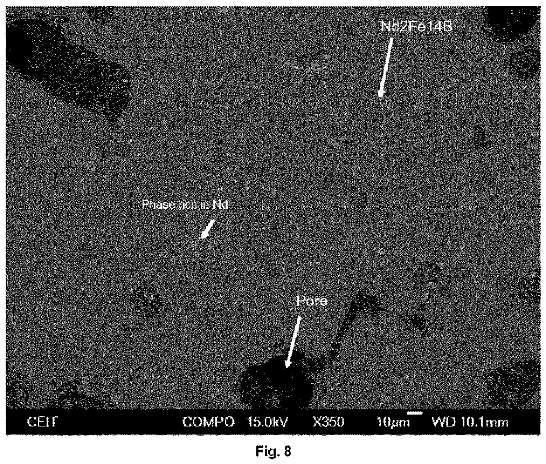

The atomised powder is subject to a temperature of 1150 ºC during 24 hours. If the neodymium content is 27% by weight, a change in the microstructure takes place with the formation of a large quantity of αFe phase, which deteriorates the magnetic properties since it is a soft ferromagnetic phase (Figure 7). If the neodymium content is 31% by weight, this change in the microstructure does not take place (Figure 8).

## Claims

1. Process for obtaining an NdFeB precursor material, comprising the stages of:
- atomising the melt NdFeB alloy until obtaining an average particle size between 30 and 250 microns, measured by means of laser diffraction, and
- annealing the particles obtained in the prior atomisation stage,
**characterised in that** the annealing process is carried out at a temperature between 1,000 and 1,800 ºC during a period of time between 1 and 1,000 hours.

2. The process according to claim 1, in which the temperature of the annealing stage is comprised between 1,100 and 1,150 ºC, and the annealing time is comprised between 10 and 300 hours.

3. The process according to claim 1 or claim 2, in which the D90 of the particles obtained during the atomisation stage is comprised between 30 and 250 microns.

4. The process according to claim 3, in which the D90 is comprised between 50 and 250 microns.

5. The process according to claim 3, in which the D90 is comprised between 95 and 150 microns.

6. The process according to claims 3 to 5, in which the D50 of the particles obtained during the atomisation stage is comprised between 10 and 70 microns.

7. The process according to claim 6, in which the D50 is comprised between 25 and 60 microns.

8. The process according to claims 3 to 7, in which the D10 is comprised between 3 and 15 microns.

9. The process according to claim 8, in which the D10 is comprised between 5 and 12 microns.

10. The process according to claim 4, in which the D50 of the particles obtained during the atomisation stage is comprised between 10 and 70 microns, the D10 is comprised between 3 and 15 microns, and the fraction by weight in powder under 250 microns is from 92% to 98.5% by weight, and the fraction by weight in powder under 150 microns is from 75% to 99% by weight.

11. The process according to claim 5, in which the D50 of the particles obtained during the atomisation stage is comprised between 25 and 60 microns, the D10 is comprised between 5 and 12 microns, the fraction by weight in powder under 250 microns is from 92% to 92.5 % by weight, and the fraction by weight in powder under 150 microns is from 80% to 95 % by weight.

12. The process as claimed in any one of the aforementioned claims, in which the composition of the melt alloy is:
Nd + Pr + La + Ce: 15-36 % by weight
B: 0.8 - 1 % by weight
Dy + Tb + Gd + Ho: 0 - 15 % by weight
Co + Cr + Mn + Ni: 0 - 15 % by weight
Al + Si: 0.2 - 2 % by weight
Ga: 0 - 3 % by weight
Cu. 0 - 3 % by weight
Nb + V + Zr: 0 - 4 % by weight
remainder: iron,
with the condition that the total content of rare earths is higher than 28% by weight.

13. The process according to the aforementioned claim, in which the total content of rare earths comprises between 28 and 31% by weight.

14. The process as claimed in any one of the claims 1 to 13, which comprises starting from the precursor material obtained after the annealing stage and, by means of a powder manufacturing treatment, such as grinding, transforming the precursor material into powder.

15. Magnetic powder obtained according to any one of the claims 1 to 14, **characterized in that** it has an average particle size comprising between 30 and 250 microns, and it is equiaxed and monocrystalline.

16. Magnet comprising the precursor material according to claim 15.

17. Procedure for obtaining the magnet according to claim 16 by subjecting the magnetic powder according to claim 14 to consolidation or compression moulding.

18. Procedure according to claim 17, in which the consolidation is carried out by means of bonding.
